Europäisches Patentamt

European Patent Office

Office européen des brevets

(11) Veröffentlichungsnummer: **0 367 865 B1**

# EUROPÄISCHE PATENTSCHRIFT

(45) Veröffentlichungstag der Patentschrift: **04.03.92**

(21) Anmeldenummer: **88118880.9**

(22) Anmeldetag: **11.11.88**

(51) Int. Cl.⁵: **G01P 3/489**, G01R 23/10

(54) **Verfahren zur Bestimmung des Messwertes einer Geschwindigkeit oder Drehzahl eines Objektes.**

(43) Veröffentlichungstag der Anmeldung:
**16.05.90 Patentblatt 90/20**

(45) Bekanntmachung des Hinweises auf die
Patenterteilung:
**04.03.92 Patentblatt 92/10**

(84) Benannte Vertragsstaaten:
**DE ES FR GB IT**

(56) Entgegenhaltungen:
**EP-A- 0 059 433**
**US-A- 3 567 913**

**IEEE TRANSACTIONS ON INDUSTRIAL ELEC-
TRONICS, Band IE-30, Nr. 4, November 1983,
Seiten 369-373, IEEE, New York, US; N.
CHAUDHURI et al.: "Wide-range precision
speed measurement with adaptive optimization using a microcomputer"**

(73) Patentinhaber: **SIEMENS AKTIENGESELL-
SCHAFT**
**Wittelsbacherplatz 2**
**W-8000 München 2(DE)**

(72) Erfinder: **Rauner, Hans, Dr.-Ing.**
**Evermod-Groll-Weg 7**
**W-8415 Nittenau(DE)**
Erfinder: **Grauvogl, Erwin, Dipl.-Ing.(FH)**
**Sonnenstrasse 8**
**W-8411 Sinting(DE)**
Erfinder: **Gerl, Gerhard, Dipl.-Ing.(FH)**
**Altdorferstrasse 4**
**W-8405 Donaustauf(DE)**
Erfinder: **Forster, Josef, Dipl.-Math.**
**Schulhütte 16**
**W-8404 Wörth(DE)**

**Beschreibung**

Die Erfindung betrifft ein Verfahren gemäß Obergriff von Anspruch 1.

Bei einer aus EP-B-0 059 433 bekannten Vorrichtung dieser Art erstreckt sich das Meßintervall über ein vorgegebenes Mindestintervall, so daß die Bestimmung eines neuen Meßwertes immer erst nach Ablauf dieses Mindestintervalles möglich ist. Daher ist ein derartiges Meßverfahren nur mit Einschränkungen verwendbar, wenn die Meßwerte in unregelmäßigen Zeitabständen, die auch kleiner als das Mindestintervall sein können, abgerufen werden, wie es beispielsweise bei Vortriebs- oder Bremsregelsystemen vorkommt.

Außerdem ist es in dem bekannten Fall nicht möglich, den Stillstand des Fahrzeugs zuverlässig zu ermitteln, da zur Bestimmung eines neuen Meßwertes grundsätzlich Meßimpulse erforderlich sind, solche aber bei Stillstand des Fahrzeugs nicht erzeugt werden.

Es ist daher Aufgabe der Erfindung, ein Verfahren der eingangs genannten Art so weiter zu bilden, daß zu beliebigen Zeiten ankommende Meßwertabrufe unverzüglich mit einem Meßwert beantwortet werden.

Die Lösung dieser Aufgabe ist in Anspruch 1 gekennzeichnet. Danach wird im wesentlichen jedem Meßimpuls ein Zeitwert in Form des Zählerstandes eines Taktzählers zugeordnet, so daß bereits nach zwei Meßimpulsen ein Neuwert des Meßwertes berechnet werden kann. Die Dauer eines Meßintervalles ist dabei begrenzt durch den letzten Meßimpuls vor einem Meßwertabruf und somit - im Gegensatz zum Stand der Technik - variabel.

Eine Weiterbildung der Erfindung ermöglicht es darüberhinaus, einen Meßwert sogar dann abzurufen, wenn seit dem letzten Meßwertabruf kein oder nur ein Meßimpuls eingetroffen ist: Hierzu wird die Dauer des Abfrageintervalles mit der eines Grenzintervalles verglichen, das dem Abstand zweier Meßimpulse bei der niedrigsten in Betracht kommenden Grenzgeschwindigkeit entspricht: Ist daher die Dauer des Abfrageintervalls größer als dieses Grenzintervall und liegt in dem Abfrageintervall kein oder nur ein Meßimpuls, dann ist die Geschwindigkeit gleich oder kleiner als die Grenzgeschwindigkeit. In diesem Fall wird dann als Neuwert Null ausgegeben. Je nach Anwendungsfall kann auch die Grenzgeschwindigkeit als Neuwert ausgegeben werden.

Ist dagegen bei einem Meßwertabruf die Dauer des Abfrageintervalls kleiner als das Grenzintervall und ist keine Neuberechnung auf der Grundlage gespeicherter End- und Anfangswerte möglich, dann wird der beim letzten Meßwertabruf berechnete Altwert ausgegeben und die Messung fortgesetzt. Aus dem Differenzwert zwischen dem Zählerstand des Taktzählers zum Zeitpunkt des Meßwertabrufes und dem gespeicherten Anfangswert ist sogar die Aussage möglich, daß die Geschwindigkeit kleiner sein muß als die Geschwindigkeit, die dem Qotienten aus dem Wegintervall zwischen zwei Zähnen des Sensors und der Dauer des Abfrageintervalles entspricht.

Ein weiterer Vorteil der Erfindung besteht darin, daß nach einem Meßwertabruf als Beginn einer neuen Messung der Zeitpunkt des letzten Meßimpulses der vorhergehenden Messung genommen werden kann. Dadurch kann bei Eintreffen nur eines weiteren Meßimpulses bis zum nächsten Meßwertabruf bereits ein neuer Meßwert berechnet werden.

In der Regel werden die Meßimpulse durch Programmroutinen verarbeitet, wobei die eintreffenden Meßimpulse zunächst in einen Pufferspeicher abgelegt werden. Bei hoher Geschwindigkeit und häufigen Meßwertabrufen ergibt sich dann eine hohe Belastung des Rechners; außerdem wäre ein Speicher mit großer Kapazität erforderlich. Probleme dieser Art lassen sich ohne unzulässige Beeinträchtigung der Meßwerte gemäß einer Weiterbildung der Erfindung dadurch vermeiden, daß die Erfassung von Meßimpulsen je Meßintervall gesperrt wird, sobald deren Zahl einen Maximalwert erreicht, der, ebenso wie die Häufigkeit der Meßwertabrufe, den Erfordernissen entsprechend festgesetzt werden kann.

Besonders vorteilhaft ist es im Rahmen der Erfindung, mit einem Taktzähler zu arbeiten, dessen Zählerkapazität in Verbindung mit der Frequenz der Taktimpulse ausreicht, um die größtmögliche Zeit zwischen zwei Taktimpulsen bei der niedrigsten Geschwindigkeit zu überstreichen. Das ermöglicht es, ohne Überlaufzähler auszukommen. Hierzu wird der Differenzwert zwischen dem Zählerstand des Taktzählers und dem gespeicherten Anfangswert überwacht und ein neues Abfrageintervall initialisiert, wenn dieser Differenzwert einen Grenzwert erreicht, der von der Zählerkapazität abhängt; im wesentlichen wird dieser Grenzwert durch die Kapazität des Taktzählers gegeben sein.

Die Erfindung wird anhand der Figuren näher erläutert; es zeigen:

Figur 1 ein Blockdiagramm einer Vorrichtung zur Durchführung des Verfahrens,

Figur 2 ein Zustandsdiagramm zur Erläuterung des erfindungsgemäßen Verfahrens, und

Figur 3 ein Diagramm zur Erklärung der Ermittlung eines Meßwertes.

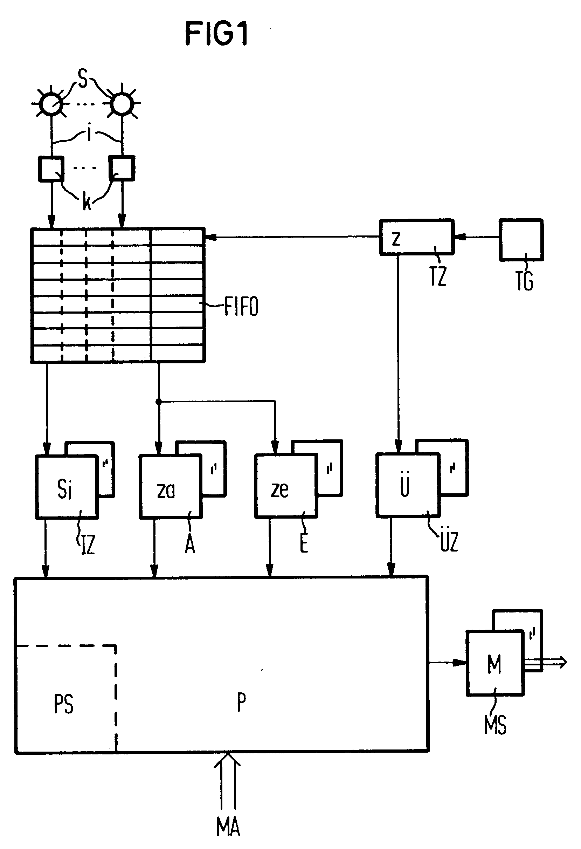

Die Anordnung nach Figur 1 ist zur Ermittlung der Geschwindigkeiten aller vier Räder eines Fahrzeuges geeignet. Sie besteht im wesentlichen aus einer elektronischen Recheneinheit P und enthält zusätzlich einen Programmspeicher PS für ein Programm zur Durchführung des erfindungsgemäßen Verfahrens, einen Taktgenerator TG, einen dessen Taktimpulse zählenden Taktzähler TZ sowie - für jedes Rad - einen Meßimpulszähler IZ, einen Primärspeicher A für den Anfangswert za, einen Sekundärspeicher E für den Endwert ze, einen Überlaufzähler ÜZ für die Überläufe des Taktzählers TZ und einen Meßwertspeicher MS für die Meßwerte M.

Die mehrfach vorhandenen, den einzelnen Rädern zugeordneten Zähler und Speicher sind in Figur 1 durch hintereinander liegende Kästchen dargestellt. Dort ist durch Pfeile lediglich die Flußrichtung der Informationen angedeutet. Von der Rechenschaltung ausgegebene Steuerbefehle an die Zähler und Speicher sind nicht dargestellt.

Jedem Rad ist ein Sensor S zugeordnet, welcher bei einer Bewegung des Rades Meßimpulse i erzeugt, wobei dem Zeitabstand zwischen zwei Meßimpulsen ein Wegintervall ds entspricht. Jedem Sensor S ist ein Kennungsgeber K zugeordnet, welcher jeden Meßimpuls i in eine Kennummer zur Identifikation des Rades, von welchem der Impuls stammt, umwandelt. Diese Kennummer wird im Augenblick des Erscheinens des Meßimpulses i in einen Zwischenspeicher FIFO zusammen mit dem Zählerstand z des Taktzählers TZ eingeschrieben. Jeder Meßimpuls i von einem der vier Räder erzeugt also in dem Zwischenspeicher FIFO einen Eintrag, bestehend aus Kennummer und momentanem Zählerstand z. Bei gleichzeitigem Erscheinen der Meßimpulse von mehreren Rädern können zusammen mit dem Zählerstand z des Taktzählers TZ die Kennummern aller betroffenen Räder in den Zwischenspeicher FIFO eingetragen werden. Wird für jedes Rad ein eigener Zwischenspeicher vorgesehen, so sind radspezifische Kennnummern nicht erforderlich.

Diese Einträge werden von einem Hilfsprogramm nacheinander abgearbeitet, das von jedem Meßimpuls gestartet wird (sofern es nicht schon oder noch läuft). Jeder Eintrag verursacht bei dem durch die Kennummer identifizierten Meßimpulszähler IZ die Erhöhung der Meßimpulssumme Si um den Wert 1. Gleichzeitig wird der zugehörige Zählerstand z je nach der Größe der Meßimpulssumme Si entweder bei Si = 1 als Anfangswert za in den Primärspeicher A oder bei Si größer 1 als Endwert ze in den Sekundärspeicher E des jeweiligen Rades eingeschrieben. Überläufe Ü des Taktzählers werden, falls erforderlich, für jedes Rad getrennt, beginnend mit dem jeweiligen Anfangswert za, in einem Überlaufzähler ÜZ gezählt.

Aus den in den Zählern IZ und ÜZ sowie in den Speichern A und E enthaltenen Daten pro Rad errechnet die Recheneinheit P mittels eines Hauptprogrammes, das durch einen von außen kommenden Meßwertabruf MA gestartet wird, einen Meßwert Mneu, speichert diesen im Meßwertspeicher MS ab und gibt ihn gleichzeitig über einen Ausgabekanal ab.

Wahlweise kann jeder Meßwertabruf MA die Ausgabe je eines Meßwertes M aller Räder bewirken oder es kann pro Meßwertabruf der Meßwert nur eines Rades ausgegeben werden, wobei die Meßwerte der einzelnen Räder zyklisch abgerufen werden. Auf diese Weise kann, wenn die Meßwerte nicht schnell benötigt werden, Rechner-und Speicherkapazität gespart werden. Einzelheiten des erfindungsgemäßen Verfahrens werden im folgenden für ein einziges Rad erläutert:

Die von einem am Rad angeordneten Bewegungssensor S kommenden Meßimpulse i werden in dem Meßimpulszähler IZ gezählt, wobei jedem zwischen zwei aufeinander folgenden Meßimpulsen i liegendem Zeitintervall ein bestimmtes Wegintervall ds (Weg oder Drehwinkel) entspricht. Zur Berechnung eines Meßwertes ist daher die Zahl der Wegintervalle ds und der Taktimpulse in einem Meßintervall MI zu ermitteln, das innerhalb eines Abfrageintervalles AI liegt und durch den ersten und letzten Meßimpuls im Abfrageintervall begrenzt ist. Jedes Abfrageintervall AI beginnt mit einem Initialisierungsbefehl oder dem darauffolgenden Meßimpuls oder dem letzten Meßimpuls im vorherigen Abfrageintervall und endet mit dem nächsten Meßwertabruf MA. Zur Bestimmung der Dauer des Meßintervalls MI wird ein freilaufender Taktzähler TZ vorgegebener Stellenzahl (Taktzählerkapazität Z) verwendet, welcher von einem Taktgeber TG erzeugte Taktimpulse konstanter Frequenz fortlaufend zählt, deren Summe - Taktimpulssumme St - zwischen dem ersten und dem letzten Meßimpuls in dem Abfrageintervall AI ein Maß für die Dauer des Meßintervalls MI ist. Hat der Taktzähler TZ seinen Maximalstand erreicht, so läuft er beim nächsten Taktimpuls über und beginnt mit Null von neuem zu zählen.

Die Taktimpulssumme St wird berechnet, indem der Differenzwert zd zwischen dem Endwert ze und dem Anfangswert za gebildet wird (vorzeichenlose Arithmetik modulo Taktzählerkapazität). Dies setzt voraus, daß die Anzahl der Taktimpulse zwischen dem Eintreffen von zwei aufeinanderfolgenden Meßimpulsen kleiner als die Taktzählerkapazität Z ist. Anderenfalls muß für jeden Überlauf die Taktzählerkapazität Z zum Differenzwert zd hinzuaddiert werden. Als Taktzählerkapazität Z wird die maximale Anzahl unterschiedlicher Taktzählerzustände verstanden. Für einen n-stelligen Dualzähler beträgt diese $Z = 2^n$.

Dieses Zählverfahren ist insbesondere bei der Messung der Radgeschwindigkeiten aller Räder eines Fahrzeuges vorteilhaft, da nur ein einziger Taktzähler für die Bestimmung der Längen der Meßintervalle aller vier Räder notwendig ist.

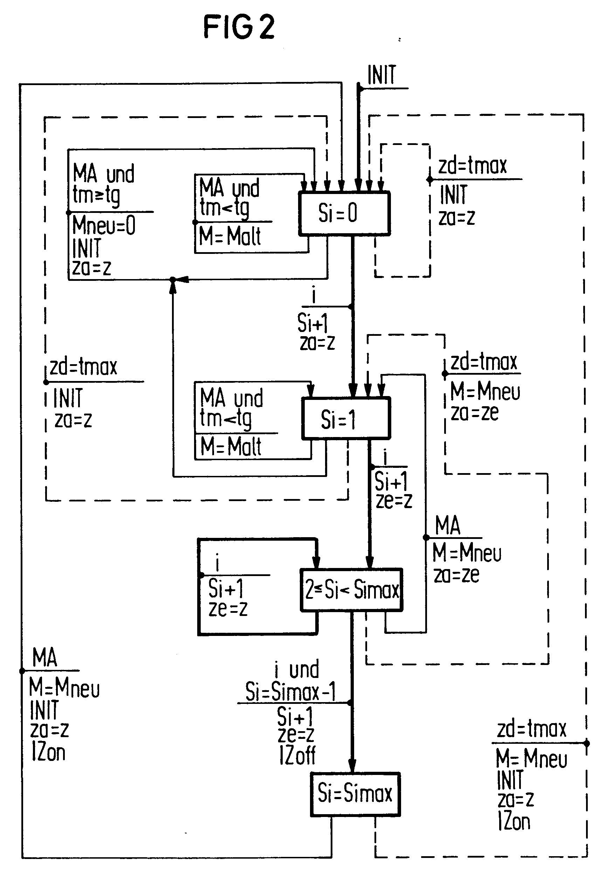

Für die Darstellung des Verfahrensablaufs in Figur 2 wurde die Form eines Zustandsdiagramms gewählt. Bestimmend für den Verfahrensablauf ist die seit dem Beginn eines Abfrageintervalls AI im Meßimpulszähler IZ registrierte Meßimpulssumme Si. Diese Meßimpulssummen Si sind in Figur 2 in Kästchen eingetragen. Sie können durch drei unterschiedliche Arten von Ereignissen beeinflußt werden:

1. Durch eintreffende Meßimpulse i, durch dicke Pfeile dargestellt,

2. durch Meßwertabrufe MA, durch dünne Pfeile dargestellt, und

3. durch Meßzeitüberschreitungen, durch gestrichelte Pfeile dargestellt.

Jeder Pfeil ist mit einer Legende versehen, die oberhalb eines waagerechten Balkens das Ereignis und darunter die daraufhin ablaufenden Verfahrensschritte angibt.

Der Beginn einer Messung - eines neuen Abfrageintervalls AI - erfolgt entweder durch einen Neustart der Messung (Initialisierungsbefehl INIT) oder durch Übernahme des Endwertes ze der unmittelbar vorausgegangenen Messung als Anfangswert za für die neue Messung.

Im Zustand 2 kleiner oder gleich Si kleiner Simax wird eine neue Messung durch Übernahme des Endwertes ze als Anfangswert za begonnen. Gleichzeitig wird der Meßimpulszähler IZ auf den Wert Eins gesetzt. In allen anderen Fällen wird eine neue Messung durch einen Initialisierungsbefehl (INIT) begonnen.

Dabei wird der Meßimpulszähler IZ auf den Wert Null gesetzt und der aktuelle Zählerstand z des Taktzählers TZ als Anfangswert za gespeichert. Der Impulszähler IZ wird zur Zählung von Meßimpulsen i freigegeben (IZon).

Mit dem Eintreffen des ersten Meßimpulses i wird die Meßimpulssumme Si auf den Wert Eins erhöht und der aktuelle Zählerstand z als Anfangswert za gespeichert.

Mit dem Eintreffen des nächsten Meßimpulses i wird die Meßimpulssumme auf Si = 2 erhöht und der momentane Zählerstand z als Endwert ze in den Sekundärspeicher E eingeschrieben. Mit jedem weiteren Meßimpuls i wird der zugehörige Zählerstand z als neuer Endwert ze gespeichert und die Meßimpulssumme Si um 1 erhöht. Dieser Vorgang wiederholt sich bei jedem weiteren Meßimpuls i solange, bis entweder ein Meßwertabruf MA erfolgt und das Abfrageintervall endet, oder die Meßimpulssumme Si einen Maximalwert Simax erreicht, bei welchem der Zählerstand z als Endwert ze im Sekundärspeicher E registriert und gleichzeitig der Meßimpulszähler IZ für weitere Meßimpulse i gesperrt wird (IZ off). In diesem Zustand verharrt der Meßimpulszähler IZ solange, bis entweder ein Meßwertabruf MA erfolgt oder der Differenzwert zd zwischen Zählerstand z und Anfangswert za einen Maximalwert tmax erreicht. Die maximale Meßimpulssumme Simax wird erreicht, wenn weder ein Meßwertabruf MA noch eine Überschreitung des Maximalwerts tmax erfolgte.

Meßwertabrufe MA können zu jeder Zeit eintreffen. Sobald im Impulszähler IZ wenigstens zwei Meßimpulse registriert sind, ist die Bestimmung eines neuen Meßwertes Mneu ohne weiteres aus der Meßimpulssumme Si und dem gespeicherten Anfangswert za sowie dem gespeicherten Endwert ze möglich.

Ist im Meßimpulszähler IZ jedoch kein oder nur ein Meßimpuls registriert, Si gleich Null oder Eins, so wird unterschieden, ob entweder eine sehr geringe Geschwindigkeit (Null) vorliegt oder ob die bisherige Dauer tm des Abfrageintervalls AI zu kurz war. Zu diesem Zweck wird ein Grenzintervall GI vorgegeben, dessen Dauer tg gerade gleich dem zeitlichen Abstand von zwei Meßimpulsen bei einer Geschwindigkeit ist, deren Wert noch angezeigt werden soll und unterhalb welcher Stillstand des Rades angenommen wird. Diese Grenzgeschwindigkeit beträgt beispielsweise 3 km/h. Bei kleineren Geschwindigkeiten wird der Meßwert "Null" ausgegeben.

Erfolgt ein Meßwertabruf MA bei einer Meßimpulssumme Si gleich Null oder Eins und ist die Dauer tm des Abfrageintervalls AI größer oder gleich der Dauer tg des Grenzintervalls GI, so liegt die Geschwindigkeit unterhalb des vorgegebenen Grenzwertes und es wird der Meßwert M = Null ausgegeben. Anschließend beginnt ein neues Abfrageintervall AI mit dem Initialisierungsbefehl INIT und Si wird auf Null gesetzt. Je nach Anwendungsfall kann statt der Geschwindigkeit "Null" auch die Grenzgeschwindigkeit ausgegeben werden.

Ist bei einem Meßwertabruf MA und einer Meßimpulssumme Si gleich Null oder Eins die Dauer tm des Abfrageintervalls AI jedoch kleiner als die Dauer tg des Grenzintervalls GI, so wäre es möglich, daß innerhalb dieses Grenzintervalls mindestens noch ein zweiter Meßimpuls i registriert wird, also eine von Null verschiedene Geschwindigkeit vorliegt. Aus diesem Grunde wird der Meßvorgang fortgesetzt (za bleibt unverändert) und inzwischen der im Speicher MS gespeicherte alte Meßwert Malt ausgegeben. Alternativ kann hier auch eine Abschätzung der Geschwindigkeit vorgenommen werden, wobei ein Meßwert so berechnet wird, als ob zum Zeitpunkt des Meßbeginns und des Meßwertabrufs Meßimpulse erschienen wären. Die tatsächliche Geschwindigkeit ist dann kleiner als dieser Rechenwert.

Erfolgt ein Meßwertabruf MA bei einer Meßimpulssumme Si größer als 1 und kleiner als Simax, so kann aus den gespeicherten Daten ein Meßwert Mneu berechnet, gespeichert und ausgegeben werden. Dann wird der letzte Meßimpuls des damit beendeten Meßintervalls MI als erster Meßimpuls des nächsten Abfrageintervalls AI und Meßintervalles MI betrachtet und der zugehörige Zählerstand ze als neuer Wert za gespeichert und Si auf 1 gesetzt.

Erfolgt schließlich ein Meßwertabruf MA bei einer Meßimpulssumme Simax, so wird aus den gespeicherten Daten ebenfalls ein neuer Meßwert Mneu berechnet, gespeichert und ausgegeben und anschließend mit dem Befehl INIT ein neues Abfrageintervall AI gestartet. Außerdem wird der Meßimpulszähler auf 0 gesetzt und für eine erneute Registrierung von Meßimpulsen i freigegeben (IZ on).

Besonders vorteilhaft ist es, einen Taktzähler ausreichender Kapazität Z zu verwenden, da dann die Differenzbildung besonders einfach wird und kein Überlaufzähler abgefragt werden muß. Dann muß aber sichergestellt werden, daß der Differenzwert zd zwischen Zählerstand z und dem Anfangswert za des laufenden Abfrageintervalles einen durch die Kapazität Z des Taktzählers bestimmten Grenzwert tmax nicht übersteigt. Entspricht daher der Differenzwert zd dem Grenzwert tmax und liegt kein Meßwertabruf vor, so werden, in Figur 2 durch gestrichelte Pfeile dargestellt, je nach Meßimpulssumme Si unterschiedliche Verfahrensschritte eingeleitet: Beträgt die Meßimpulssumme Si = Null oder 1, so wird mit dem Befehl INIT ein neues Abfrageintervall AI gestartet und der Meßimpulszähler IZ auf Null gesetzt.

Ist die Meßimpulssumme Si mindestens 2 und kleiner als Simax, so wird ein neuer Meßwert Mneu berechnet und gespeichert und der Meßimpulszähler auf 1 gesetzt und anschließend ein neues Abfrageintervall AI begonnen. Es wird in diesem Fall somit - wie bei einem Meßwertabruf - wieder der letzte Meßimpuls des vorherigen Abfrageintervalls als erster Meßimpuls des neuen Abfrageintervalls bestimmt.

Ist die Meßimpulssumme Si gleich dem Maximalwert Simax, so wird wie bei einem Meßwertabruf MA ein neuer Meßwert Mneu berechnet und der Neustart einer Messung eingeleitet.

Die Überwachung zd größer tmax kann entfallen, wenn gewährleistet ist, daß die Zeit zwischen zwei Meßwertabrufen MA stets kleiner oder gleich tmax ist. Auf diese Weise ist eine Vereinfachung des Verfahrens erzielbar.

Die Grenzen eines Meßintervalls MI und die Bestimmung seiner Dauer zur Berechnung der momentanen Geschwindigkeit mittels des vorstehend beschriebenen Verfahrens wird an einem einfachen Beispiel erklärt, bei welchem als Taktzähler TZ ein vierstelliger Dualzähler Verwendung findet. Überläufe des Taktzählers sollen vorerst nicht berücksichtigt werden, d. H., Die Länge tm eines Abfrageintervalls AI muß kleiner als die Taktzählerkapazität Z sein.

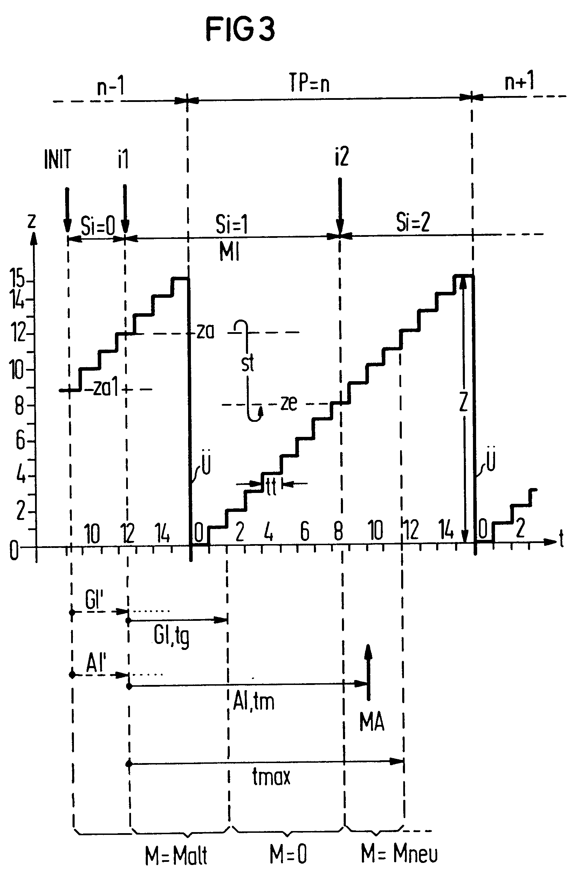

Bei dem in Figur 3 dargestellten Diagramm ist auf der Ordinate der Taktzählerstand z und auf der Abszisse die Zeit t aufgetragen.

Als vierstelliger Dualzähler kann der Taktzähler TZ sechzehn verschiedene Werte annehmen, nämlich die Werte Null bis 15 (= Taktzählerkapazität Z). Ein Durchlauf des Taktzählers von Null bis 15 wird als Taktzählerperiode TP bezeichnet. In Figur 3 ist eine volle Taktzählerperiode $TP = n$ dargestellt sowie der letzte Teil der vorherigen Taktzählerperiode $TP = n - 1$ und der erste Teil der folgenden Taktzählerperiode $TP = n + 1$. Dies ergibt fortlaufend sägezahnähnliche Treppenkurven.

Die nachstehend angegebenen Formeln zur Berechnung der Dauer St des Meßintervalls MI beziehen sich auf digitale Rechenweise.

Mit der Vorgabe, daß keine Überläufe Ü gezählt werden, darf die maximale Dauer tmax eines Abfrageintervalls AI und damit eines Meßintervalls MI höchstens $2^n - 1 = 15$ Takte lang sein. Wäre sie länger, so könnte die Berechnung ein falsches Ergebnis liefern.

Dabei ist es gleichgültig, welcher Taktzählerstand z als Anfangszählerstand za gespeichert wird. Wichtig ist nur, daß der Endzählerstand ze nicht mehr als 15 Takte nach za liegt. Ist ze größer als za, so wird za einfach von ze subtrahiert: $St = ze - za$. Ist jedoch za größer als ze, so wird der Komplementärwert $za^* = 2^n - za$ zu ze addiert: $St = za^* + ze$.

Soll die Dauer eines Abfrageintervalls AI größer sein als $2^n - 1$ Takte, so müssen die Überläufe Ü des Taktzählers TZ in einem Überlaufzähler ÜZ gezählt werden. Es ist dann:
$St = ze - za + 2n \cdot Ü$, wenn ze größer als za ist,
und es ist:
$St = za^* + ze + 2^n (Ü - 1)$, wenn ze kleiner als za ist.

Beginnt zum Zeitpunkt 9 (n - 1) - zu lesen: beim Taktzählerstand 9 der Taktperiode n - 1 - ein Abfrageintervall AI, in Figur 3 gekennzeichnet durch den Befehl INIT, so wird der Taktzählerstand neun als Anfangswert za1 in den Speicher A eingelesen. Die Meßimpulssumme beträgt zu diesem Zeitpunkt Si = Null. Erscheint zum Zeitpunkt 12 (n - 1) ein Meßimpuls i1, so wird der Zählerstand za = 12 anstelle des gespeicherten Wertes za1 in den Speicher A übernommen. Die Meßimpulssumme beträgt ab diesem Zeitpunkt Si = 1. Trifft zum Zeitpunkt 8 (n) ein zweiter Meßimpuls i2 ein, so beträgt ab diesem Zeitpunkt die Meßimpulssumme Si = 2. Der Taktzählerstand z = 8 wird in den Speicher E als Endwert ze eingeschrieben. Die Dauer St des Meßintervalls MI in diesem Moment beträgt: $St = (16 - 12) + 8 = 12$.

Das Grenzintervall GI' bzw. GI und das Abfrageintervall AI' bzw. AI beginnen jeweils bei dem im Speicher A stehenden Anfangswert za. In dem Diagramm in Figur 3 ist die Dauer tg des Grenzintervalls GI mit fünf Takten und die maximale Dauer tmax mit 15 Takten angegeben. Je nachdem, ob und zu welchem Zeitpunkt ein Meßwertabruf MA erfolgt, wird als Meßwert M entweder der im Meßwertspeicher MS gespeicherte Wert Malt, der Wert M = Null oder der Wert M = Mneu ausgegeben. Die Bereiche sind in Figur 3 unten durch geschweifte Klammern gekennzeichnet.

Ein neuer Meßwert je Abfrageintervall berechnet sich nach der Formel:

$$Mneu = \frac{(Si - 1) \cdot ds}{St \cdot tt} \cdot C$$

wobei ds ein vom Sensor/Rad zurückgelegtes Weg- oder Drehwinkelintervall zwischen zwei aufeinanderfolgenden Meßimpulsen i (zwischen zwei Sensorzähnen), tt die Zeit zwischen zwei Taktimpulsen und C eine Konstante bedeuten.

Auf diese Weise werden, gemäß dem Zustandsdiagramm in Figur 2, fortlaufend neue Meßwerte ermittelt.

**Patentansprüche**

1. Verfahren zur Bestimmung und Abfrage des Meßwertes (M) der Geschwindigkeit oder Drehzahl eines Objektes, insbesondere der Umfangsgeschwindigkeit eines Fahrzeugrades,
   - mit einem Sensor (S), der jeweils einen Meßimpuls (i) erzeugt, wenn sich das Objekt um ein Wegintervall (ds) fester Größe weiterbewegt,
   - mit einem Taktgeber (TG) zur Erzeugung von Taktimpulsen konstanter Taktfrequenz, wobei
     - - die Summe der Meßimpulse - Meßimpulssumme (Si) - in einem Meßintervall (MI) ermittelt wird, das durch einen ersten und einen letzten Meßimpuls (i) begrenzt wird,
     - - die Summe der Taktimpulse - Taktimpulssumme (St) - während des Meßintervalles (MI) ermittelt wird,
     - - ein Neuwert des Meßwertes (M) je Meßintervall aus Meßimpulssumme (Si) und Taktimpulssumme (St) berechnet und ausgegeben wird,
   **dadurch gekennzeichnet,**
   - daß beim Eintreffen jedes Meßimpulses (i) und bei jedem Initialisierungsbefehl (INIT) der Zählerstand (z) eines Taktzählers (TZ) für die Taktimpulse abgelesen und dem jeweils auslösenden Ereignis zugeordnet wird,
   - daß der dem Initialisierungsbefehl und dem ersten folgenden Meßimpuls zugeordnete Zählerstand (z) als Anfangswert (za) eines Meßintervalles (MI) und eines damit beginnenden Abfrageintervalles (AI) gespeichert wird,
   - daß der jedem folgenden Meßimpuls zugeordnete Zählerstand (z) als Endwert (ze) gespeichert wird, wobei jeder neue Zählerstand den vorhergehenden überschreibt,
   - daß bei einem Meßwertabruf (MA)
     - - das Meßintervall (MI) mit dem letzten Meßimpuls (i) endet,
     - - die Differenz zwischen Endwert (ze) und Anfangswert (za) als Taktimpulssumme (St) verwendet wird , und
     - - der Endwert (ze) als neuer Anfangswert (za) gespeichert wird, vorausgesetzt, die Meßimpulssumme (Si) ist größer Eins und kleiner als ein Maximalwert (Simax).

2. Verfahren nach Anspruch 1,
   **dadurch gekennzeichnet,**
   - daß das Abfrageintervall (AI) vorläufig mit einem Meßwertabruf (MA) endet und seine Dauer (tm) mit der (tg) eines Grenzintervalles (GI) verglichen wird, wenn weniger als zwei Meßimpulse in dem Abfrageintervall (Si kleiner 2) liegen,
   - daß bei einer Dauer (tm) des vorläufigen Abfrageintervalls (AI) kleiner als die (tg) des Grenzwertintervalls (GI)
     - - entweder der zuletzt ausgegebene Meßwert (Malt),
     - - oder ein Schätzwert, der so berechnet wird, als ob zum Zeitpunkt des Meßbeginns und des Meßwertabrufs Meßimpulse erschienen wären,
   
   als Neuwert (Mneu) ausgegeben und das Abfrageintervall fortgesetzt wird, und
   - daß bei einer Dauer des vorläufigen Abfrageintervalls (AI) mindestens gleich der (tg) des Grenzintervalles (GI) als Meßwert der Neuwert Null ausgegeben, ein neuer Initialisierungsbefehl (INIT) gegeben und die Meßimpulssumme (Si) auf Null gesetzt wird.

3. Verfahren nach Anspruch 1,
   **gekennzeichnet durch**
   - eine Sperrung der Erfassung von Meßimpulsen, sobald die Meßimpulssumme (Si) den Maximalwert (Simax) erreicht.

4. Verfahren nach Anspruch 3,
**dadurch gekennzeichnet,**
- daß bei einem Meßwertabruf (MA) nach Sperrung der Erfassung als Meßwert ein Neuwert auf der Basis der gespeicherten Daten für Endwert (ze) und Anfangswert (za) berechnet und ausgegeben wird, und daß danach ein neues Abfrageintervall (AI) durch einen Initialisierungsbefehl (INIT) gestartet, die Meßimpulssumme (Si) auf Null gesetzt und die Sperrung (IZoff) der Erfassung von Meßimpulsen aufgehoben wird (IZon).

5. Verfahren nach Anspruch 1,
**dadurch gekennzeichnet,**
- daß bei Verwendung eines Taktzählers (TZ) ohne Überlaufzähler der Differenzwert (zd) zwischen dem Zählerstand (z) des Taktzählers (TZ) und dem Anfangswert (za) überwacht wird und, wenn dieser Differenzwert einen von der Zählerkapazität (Z) des Taktzählers (TZ) abhängigen Grenzwert (tmax) erreicht,
- entweder als Meßwert der Neuwert Null abgespeichert und die Meßimpulssumme (Si) auf Null gesetzt und ein Initialisierungsbefehl (INIT) gegeben wird, wenn die Meßimpulssumme (Si) kleiner Zwei war,
- oder als Meßwert ein Neuwert (Mneu) aufgrund von Anfangs-und Endwert (za, ze) berechnet und gespeichert, die Meßimpulssumme (Si) auf Eins gesetzt und der Endwert (ze) als neuer Anfangswert (za) gespeichert wird, wenn die Meßimpulssumme (Si) gleich oder größer Zwei und kleiner Simax war,
- oder als Meßwert ein Neuwert (Mneu) aufgrund von Anfangs-und Endwert (za, ze) berechnet und gespeichert, die Meßimpulssumme (Si) auf Null gesetzt und ein Initialisierungsbefehl (INIT) gegeben wird, wenn die Meßimpulssumme (Si) gleich Simax war,
- und daß anschließend ein neues Abfrageintervall (AI) begonnen wird.

**Claims**

1. Method of determining and inquiring the measured value (M) of the speed or rate of rotation of an object, in particular the circumferential speed of a vehicle wheel,
- having a sensor (S), which in each case generates a measuring pulse (i) when the object proceeds by a path interval (ds) of fixed size,
- having a clock generator (TG) for generating clock pulses of constant clock frequency,
- - the sum of the measuring pulses - measuring pulse sum (Si) - being established in a measuring interval (MI) which is limited by a first and a last measuring pulse (i),
- - the sum of the clock pulses - clock pulse sum (St) - being established during the measuring interval (MI),
- - a new value of the measured value (M) being calculated from the measuring pulse sum (Si) and the clock pulse sum (St) for each measuring interval and the said new value being output,
characterised
- in that upon arrival of every measuring pulse (i) and with every initialisation instruction (INIT), the counter reading (z) of a clock counter (TZ) is read for the clock pulses and assigned to the respectively triggering event,
- in that the counter reading (z) assigned to the initialisation instruction and the first following measuring pulse is stored as an initial value (za) of a measuring interval (MI) and of an inquiry interval (AI) beginning therewith,
- in that the counter reading (z) assigned to every following measuring pulse is stored as a final value (ze), every new counter reading overwriting the preceding counter reading,
- in that, in the event of a measured value call-up (MA),
- - the measuring interval (MI) ends with the last measuring pulse (i),
- - the difference between the final value (ze) and the initial value (za) is used as the clock pulse sum (St), and
- - the final value (ze) is stored as a new initial value (za), provided that the measuring pulse sum (Si) is greater than one and less than a maximum value (Simax).

2. Method according to Claim 1, characterised
- in that the inquiry interval (AI) is provisionally ended by a measured value call-up (MA) and its duration (tm) is compared with that (tg) of a limit interval (GI) if fewer than two measuring pulses lie in the inquiry interval (Si less than 2),
- in that, given a duration (tm) of the provisional inquiry interval (AI) less than that (tg) of the limit interval (GI),
- - either the most recently output measured value (Malt),

- - or an estimated value, which is calculated as though measuring pulses had appeared at the time of the beginning of measuring and of the measured value call-up,

is output as a new value (Mneu) and the inquiry interval is continued, and

- in that, given a duration of the provisional inquiry interval (AI) at least equal to that (tg) of the limit interval (GI), the new value zero is output as the measured value, a new initialisation instruction (INIT) is given and the measuring pulse sum (Si) is set to zero.

3. Method according to Claim 1, characterised by

- an inhibiting of the acquisition of measuring pulses as soon as the measuring pulse sum (Si) reaches the maximum value (Simax).

4. Method according to Claim 3, characterised

- in that, in the event of a measured value call-up (MA) after inhibiting acquisition, a new value is calculated on the basis of the stored data for the final value (ze) and the initial value (za) and is output as the measured value, and in that thereafter a new inquiry interval (AI) is started by an initialisation instruction (INIT), the measuring pulse sum (Si) is set to zero and the inhibiting (IZoff) of the acquisition of measuring pulses is cancelled (IZon).

5. Method according to Claim 1, characterised

- in that, if a clock counter (TZ) without overflow counter is used, the difference value (zd) between the counter reading (z) of the clock counter (TZ) and the initial value (za) is monitored and, if this difference value reaches a limit value (tmax), dependent on the counter capacity (Z) of the clock counter (TZ),

- either the new value zero is stored as the measured value and the measuring pulse sum (Si) is set to zero and an initialisation instruction (INIT) is given, if the measuring pulse sum (Si) was less than two,

- or a new value (Mneu) is calculated on the basis of initial value (za) and the final value (ze) and stored as the measured value, the measuring pulse sum (Si) is set to one and the final value (ze) is stored as the new initial value (za), if the measuring pulse sum (Si) was equal to or greater than two and less than Simax,

- or a new value (Mneu) is calculated on the basis of the initial value (za) and the final value (ze) and stored as the measured value, the measuring pulse sum (Si) is set to zero and an initialisation instruction (INIT) is given, if the measuring pulse sum (Si) was equal to Simax,

- and in that subsequently a new inquiry interval (AI) is begun.

## Revendications

1. Procédé pour déterminer et interroger la valeur de mesure (M) de la vitesse ou de la vitesse de rotation d'un objet, notamment de la vitesse circonférentielle d'une roue de véhicule, comportant

- un capteur (S), qui produit une impulsion de mesure (i) lorsque l'objet se déplace sur un intervalle de déplacement (ds) possédant une valeur fixe,

- un générateur de cadence (TG) servant à produire des impulsions de cadence possédant une fréquence constante, et selon lequel

- - la somme des impulsions de mesure -somme (Si) des impulsions de mesure- est déterminée pendant un intervalle de mesure (MI), qui est limité par une première et une dernière impulsion de mesure (i),

- - la somme des impulsions de cadence -somme (St) des impulsions de cadence- est déterminée pendant l'intervalle de mesure (MI),

- - une nouvelle valeur de la valeur de mesure (M) pour chaque intervalle de mesure est calculée à partir de la somme (Si) des impulsions de mesure et de la somme (St) des impulsions de cadence et est délivrée,

caractérisé par le fait

- que lors de l'arrivée de chaque impulsion de mesure (i) et lors de chaque instruction d'initialisation (INIT), l'état (z) d'un compteur de cadence (TZ) pour les impulsions de cadence est lu et associé au phénomène déclencheur respectif,

- que l'état (s) du compteur, associé à l'instruction d'initialisation et à la première impulsion suivante de mesure, est mémorisé en tant que valeur initiale (za) d'un intervalle de mesure (MI) et d'un intervalle d'interrogation (AI) commençant par cette impulsion,

- que l'état (z) du compteur, qui est associé à chaque impulsion de mesure suivante, est mémorisé en tant que valeur finale (ze), chaque nouvel état du compteur dépassant l'état précédent,

- que dans le cas d'un appel (MA) de la valeur de mesure
  - - l'intervalle de mesure (MI) se termine par la dernière impulsion de mesure (i),
  - - la différence entre la valeur finale (ze) et la valeur initiale (za) est utilisée en tant que somme (St) des impulsions de cadence, et
  - - la valeur d'extrémité (ze) est mémorisée en tant que nouvelle valeur initiale (za), dans l'hypothèse où la somme (Si) des impulsions de mesure est supérieure à un et inférieure à une valeur maximale (Simax).

2. Procédé suivant la revendication 1, caractérisé par le fait
   - que l'intervalle d'interrogation (AI) se termine prématurément par un appel (MA) de la valeur de mesure et que sa durée (tm) est comparée à la durée (tg) d'un intervalle limite (GI), lorsque moins de deux impulsions de mesure sont situées dans l'intervalle d'interrogation (Si inférieure à 2),
   - que dans le cas où la durée (tm) de l'intervalle précédent l'interrogation (AI) est inférieure à la durée (tg) de l'intervalle limite (GI),
     - - soit la valeur de mesure (M ancienne) délivrée en dernier lieu,
     - - soit une valeur estimée, qui est calculée comme si des impulsions de mesure étaient apparues à l'instant du début de la mesure et de l'appel de la valeur de mesure, est délivrée en tant que nouvelle valeur (M nouvelle) et l'intervalle d'interrogation est prolongé, et
   - que, dans le cas où la durée de l'intervalle précédent d'interrogation (AI) est égale au moins à la valeur (tg) de l'intervalle limite (GI) en tant que valeur de mesure, la nouvelle valeur zéro est délivrée, une nouvelle instruction d'initialisation (INIT) est envoyée et la somme (Si) des impulsions de mesure est réglée à zéro.

3. Procédé suivant la revendication 1, caractérisé par
   - un blocage de la détection d'impulsions de mesure dès que la somme (Si) des impulsions de mesure atteint la valeur maximale (Simax).

4. Procédé suivant la revendication 3, caractérisé par le fait
   - que, dans le cas d'une interrogation (MA) de la valeur de mesure, après le blocage de la détermination, une nouvelle valeur est calculée et délivrée, en tant que valeur de mesure, sur la base des données mémorisées pour la valeur finale (ze) et la valeur initiale (za) et qu'ensuite un nouvel intervalle d'interrogation (AI) est déclenché par une instruction d'initialisation (INIT), la somme (Si) des impulsions de mesure est positionnée à zéro et le blocage (IZoff) de la détection d'impulsions de mesure est supprimée (IZon).

5. Procédé suivant la revendication 1, caractérisé par le fait
   - que dans le cas d'utilisation d'un compteur de cadence (TZ) sans compteur de dépassement de capacité, la valeur de différence (zd) entre l'état (z) du compteur de cadence (TZ) et la valeur initiale (za) est contrôlée, et, lorsque cette valeur de différence atteint une valeur limite (tmax) qui dépend de la capacité (Z) du compteur de cadence (TZ),
   - soit la nouvelle valeur zéro est mémorisée en tant que valeur de mesure et la somme (Si) des impulsions de mesure est positionnée à zéro et une instruction d'initialisation (INIT) est délivrée lorsque la somme (Si) des impulsions de mesure est inférieure à deux,
   - soit une valeur nouvelle (M nouvelle) est calculée et mémorisée, en tant que valeur de mesure, sur la base de la valeur initiale et de la valeur finale (za,ze), la somme (Si) des impulsions de mesure est positionnée à un et la valeur finale (ze) est mémorisée en tant que nouvelle valeur initiale (za), lorsque la somme (Si) des impulsions de mesure est égale ou supérieure à deux et inférieure à Simax,
   - soit une nouvelle valeur (M nouvelle) est calculée et mémorisée en tant que valeur de mesure sur la base de la valeur initiale et de la valeur finale (za,ze) et une instruction d'initialisation (INIT) est délivrée lorsque la somme (Si) des impulsions de mesure est égale à Simax, et
   - qu'ensuite un nouvel intervalle d'interrogation (AI) commence.

FIG1

EP 0 367 865 B1

# FIG 2

11

# FIG 3